# EUROPEAN PATENT APPLICATION

(11) **EP 4 517 801 A1**
(43) Date of publication of application: **05.03.2025**
(21) Application number: 23796125.5
(22) Date of filing: 12.04.2023
(51) Int. Cl.: H01L 21/365, H01L 21/31, H01L 21/316, H01L 21/368

(54) **FILM FORMING METHOD, FILM FORMING APPARATUS, AND MULTILAYER BODY**

(30) Priority: 25.04.2022 JP 2022071782
(71) Applicant: SHIN-ETSU CHEMICAL CO., LTD., Tokyo 1000005 (JP)
(72) Inventor: HASHIGAMI, Hiroshi, Annaka-shi, Gunma 379-0195 (JP)
(74) Representative: Sonnenhauser, Thomas Martin
(86) International application number: PCT/JP2023/014928
(87) International publication number: WO 2023/210381

(57) **Abstract**

The present invention is a forming method including the steps of atomizing a raw material solution to form a raw material mist, mixing the raw material mist and a carrier gas to form a gas mixture, placing a substrate on a stage, forming a film on the substrate by a thermal reaction by supplying the gas mixture to the substrate from a gas mixture supply means, and exhausting the gas mixture after the film formation by an exhaust means, in which a channel plate is arranged above the substrate so as to face the substrate via a space, a gas mixture flow is formed in the space above the substrate flowing linearly from the gas mixture supply means to the exhaust means such that the gas mixture flow flows along at least a part of a main surface of the substrate, and in the forming step and the exhausting step, at least a temperature T1 of the gas mixture supply means, and a temperature T2 of the channel plate are controlled. This provides the film forming method and a film forming apparatus that can stably produce a high-quality film on a large-diameter substrate surface.

## Description

### TECHNICAL FIELD

The present invention relates to a film forming method and a film forming apparatus.

### BACKGROUND ART

As a method capable of forming an epitaxial film, etc., at low temperature and atmospheric pressure, a film-forming method using fine particles of water, such as a mist CVD method, is known. Patent Document 1 discloses a film forming apparatus to form a film by supplying a raw material mist to a substrate from a nozzle arranged with being tilted to the substrate. Moreover, Patent Document 2 discloses a film forming method in which a raw material mist is transported into a reaction vessel by a carrier gas and then swirl flow is generated to make the mist react with the substrate.

### CITATION LIST

### PATENT LITERATURE

Patent Document 1: JP 2018-142637 A
Patent Document 2: JP 2016-146442 A

### SUMMARY OF INVENTION

### TECHNICAL PROBLEM

However, these conventional film forming apparatuses are unable to sufficiently control a raw material mist on substrates, and as a result, it is difficult to form a film of uniform thickness on a large diameter substrate of practical size. In addition, the temperature of a mist is changed due to continuous heating of a nozzle or a film forming chamber, frequently resulting in adhesion of powder to a substrate surface as evaporation of the mist proceeds, or in the case of crystal growth, a formation of abnormal growth grains. These foreign substances thereof not only adversely affect, e.g., characteristics of a semiconductor device but also act as a stress source when a film growth proceeds so as to cover the foreign substance described above, causing a problem in which film cracking over an extensive area is generated and quality and yield of the film are degraded.

The present invention has been made to solve the above-described problem. An object of the present invention is to provide a film forming method and a film forming apparatus capable of stably producing a high-quality film on a large-diameter substrate surface.

### SOLUTION TO PROBLEM

To solve the above problem, the present invention provides a film forming method comprising the steps of:
atomizing a raw material solution to form a raw material mist;
mixing the raw material mist and a carrier gas to form a gas mixture;
placing a substrate on a stage;
forming a film on the substrate by a thermal reaction by supplying the gas mixture to the substrate from a gas mixture supply means; and
exhausting the gas mixture after the film formation by an exhaust means, wherein
a channel plate is arranged above the substrate so as to face the substrate via a space,
a gas mixture flow is formed in the space above the substrate flowing linearly from the gas mixture supply means to the exhaust means such that the gas mixture flow flows along at least a part of a main surface of the substrate, and
in the forming step and the exhausting step, at least a temperature T1 of the gas mixture supply means, and a temperature T2 of the channel plate are controlled.

According to such a film forming method, degeneration of the raw material mist and generation of powder are suppressed, suppressing formation of a defect; moreover, a raw material yield is satisfactorily maintained, making the film forming method capable of stably producing a high-quality film on a large-diameter substrate surface.

In this case, a temperature T3 of the exhaust means may be further controlled.

According to such a film forming method, discharge of the gas mixture can be performed more efficiently, resulting in the film forming method capable of producing the high-quality film more stably.

In addition, the present invention provides a film forming method comprising the steps of:
atomizing a raw material solution to form a raw material mist;
mixing the raw material mist and a carrier gas to form a gas mixture;
placing a substrate on a stage;
forming a film on the substrate by a thermal reaction by supplying the gas mixture to the substrate from a gas mixture supply means; and
exhausting the gas mixture after the film formation by an exhaust means, wherein
a channel plate is arranged above the substrate so as to face the substrate via a space,
a gas mixture flow is formed in the space above the substrate flowing linearly from the gas mixture supply means to the exhaust means such that the gas mixture flow flows along at least a part of a main surface of the substrate, and
in the forming step and the exhausting step, at least a temperature T2 of the channel plate is controlled.

According to such a film forming method, degeneration of the raw material mist and generation of powder are suppressed, suppressing formation of a defect; moreover, a raw material yield is satisfactorily maintained, making the film forming method capable of stably producing a high-quality film on a large-diameter substrate surface.

In this case, a temperature T3 of the exhaust means may be further controlled.

According to such a film forming method, discharge of the gas mixture can be performed more efficiently, resulting in the film forming method capable of producing the high-quality film more stably.

Moreover, the present invention provides a film forming apparatus comprising:
an atomizing means for atomizing a raw material solution to form a raw material mist;
a carrier gas supply means to transport the raw material mist;
a gas mixture supply means to supply a gas mixture, in which the raw material mist and the carrier gas are mixed, to a surface of a substrate;
a stage on which the substrate is placed;
an exhaust means to exhaust the gas mixture;
a channel plate arranged above the substrate so as to face the substrate via a space; and
a temperature control means to control at least a temperature T1 of the gas mixture supply means and a temperature T2 of the channel plate.

According to such a film forming apparatus, degeneration of the raw material mist and generation of powder are suppressed, suppressing formation of a defect; moreover, a raw material yield is satisfactorily maintained, making the film forming apparatus capable of stably producing a high-quality film on a large-diameter substrate surface.

In this case, the temperature control means may further comprise a temperature control means to control a temperature T3 of the exhaust means.

According to such a film forming apparatus, discharge of the gas mixture can be performed more efficiently, resulting in the film forming apparatus capable of producing the high-quality film more stably.

Moreover, the present invention provides a laminate comprising:
a crystal substrate; and
a crystal film epitaxially grown on the crystal substrate, wherein
a density of a foreign substance having a diameter of 0.3 µm or more on a surface of the crystal film is 1 cm⁻² or less.

Such a laminate has a high-quality film on a large-diameter substrate surface.

In this case, it is preferred that the crystal film has a film thickness of 0.3 µm or more.

Such an inventive laminate is more preferable.

### ADVANTAGEOUS EFFECTS OF INVENTION

According to the present invention, the highly-productive film forming method and film forming apparatus capable of stably producing the high-quality film on the large-diameter substrate surface can be obtained.

### BRIEF DESCRIPTION OF DRAWINGS

FIG. 1 is a view illustrating one form of a film forming apparatus according to the present invention.
FIG. 2 is a view illustrating one form of a film forming unit according to the present invention.
FIG. 3 is a view illustrating another form of a film forming unit according to the present invention.

### DESCRIPTION OF EMBODIMENTS

As described above, development of a film forming method and a film forming apparatus capable of stably producing a high-quality film on a large-diameter substrate surface has been desired.

To solve the above problem, the present inventors have earnestly studied and found out that by arranging a channel plate above the substrate so as to face the substrate via a space, and by controlling a temperature T1 of the gas mixture supply means, and a temperature T2 of the channel plate, a high-quality film can be stably produced on a large-diameter substrate surface. This finding has led to the completion of the present invention.

That is, the present invention is a film forming method comprising the steps of:
atomizing a raw material solution to form a raw material mist;
mixing the raw material mist and a carrier gas to form a gas mixture;
placing a substrate on a stage;
forming a film on the substrate by a thermal reaction by supplying the gas mixture to the substrate from a gas mixture supply means; and
exhausting the gas mixture after the film formation by an exhaust means, wherein
a channel plate is arranged above the substrate so as to face the substrate via a space,
a gas mixture flow is formed in the space above the substrate flowing linearly from the gas mixture supply means to the exhaust means such that the gas mixture flow flows along at least a part of a main surface of the substrate, and
in the forming step and the exhausting step, at least a temperature T1 of the gas mixture supply means, and a temperature T2 of the channel plate are controlled.

Furthermore, the present invention provides a film forming apparatus comprising:
an atomizing means for atomizing a raw material solution to form a raw material mist;
a carrier gas supply means to transport the raw material mist;
a gas mixture supply means to supply a gas mixture, in which the raw material mist and the carrier gas are mixed, to a surface of a substrate;
a stage on which the substrate is placed;
an exhaust means to exhaust the gas mixture;
a channel plate arranged above the substrate so as to face the substrate via a space; and
a temperature control means to control at least a temperature T1 of the gas mixture supply means and a temperature T2 of the channel plate.

Hereinafter, the present invention will be described in detail with reference to the drawings. However, the present invention is not limited thereto.

### [Film Forming Apparatus]

Firstly, an example of a film forming apparatus usable for the inventive film forming method is described.

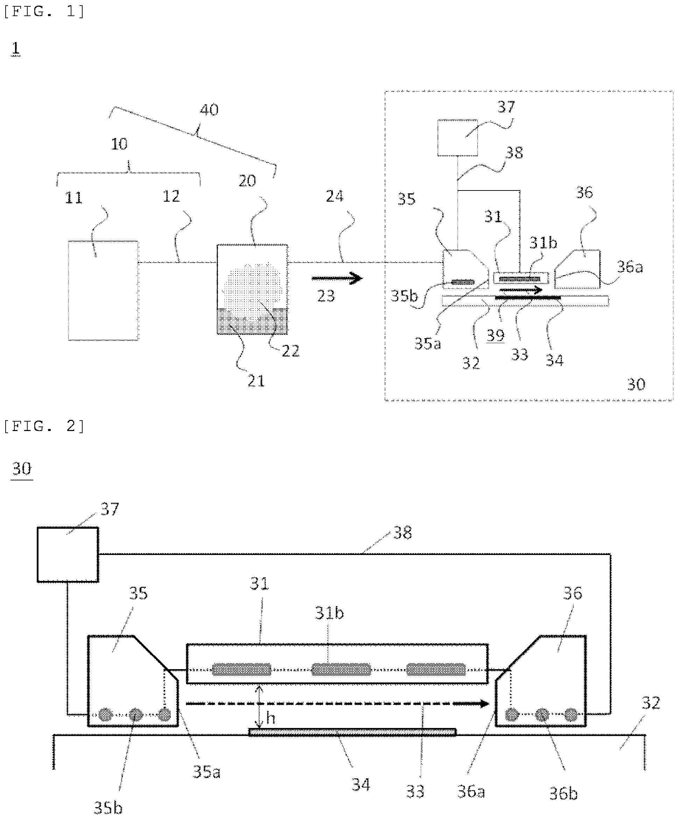

FIG. 1 shows a typical example of a film forming apparatus usable for the inventive film forming method. However, the film forming apparatus that can perform the inventive film forming method is not limited to the film forming apparatus shown in FIG. 1.

A film forming apparatus 1 shown in FIG. 1 includes a carrier gas 11, a carrier gas pipe 12, an atomizing means 20, a mist pipe 24, a gas mixture supply means 35, a stage 32, a channel plate 31, and an exhaust means 36; and a substrate 34 on which a film is formed is placed on a stage 32. Moreover, the gas mixture supply means 35 and the channel plate 31 are provided with temperature adjusting units 35b and 31b, and the temperature adjusting units 35b and 31b are connected to a temperature control unit 37 via a connecting unit 38 to configure a temperature control means. A carrier gas supply means 10 is configured with the carrier gas 11 and the carrier gas pipe 12. In addition, a film forming unit 30 is configured with the gas mixture supply means 35, the stage 32, the channel plate 31, the exhaust means 36, the temperature control unit 37, and the connecting unit 38. Note that 35a is a discharge port, and 36a is an exhaust port.

In the atomizing means 20, a raw material solution 21 is stored as a raw material. The raw material solution 21 is not particularly limited as long as the solution can be atomized (also referred to as "misted"); and aqueous solutions containing the raw material according to purpose, and organic solvent solutions such as alcohols, ketones, esters, ethers, amides, halogenated solvents, aromatic compounds, etc., are applicable.

The raw material solution 21 is atomized using known means to form a raw material mist 22.

The atomizing means 20 is further supplied with the carrier gas 11, and then the carrier gas is mixed with the raw material mist 22 to form a gas mixture 23. The carrier gas supply means 10 and the atomizing means 20 can be regarded to configure mechanism 40 to form the gas mixture 23.

The substrate 34 is placed on the stage 32, and the substrate 34 may be heated to a temperature suitable for film forming by heating means, which is not shown in the drawings.

The gas mixture 23 is transported by the mist pipe 24, and supplied the gas mixture supply means 35.

From the gas mixture supply means 35, a gas mixture 33 is supplied to a space 39 formed between the channel plate 31 and the stage 32, flowing parallel to the surface for placing the substrate on the stage 32, and is supplied to the substrate 34 placed on the stage 32, in particular, to a surface of the substrate 34. In this process, the gas mixture 33 is reacted on the substrate 34 and a film is formed on the substrate 34.

Meanwhile, the gas mixture supply means 35 and the channel plate 31 are controlled at a temperature suitable for film forming by the temperature control unit 37.

An excess portion of the gas mixture 33 that does not contribute to the film formation and a by-product generated during the reaction of the gas mixture 33 on the substrate 34 are sucked and discharged outside the system by the exhaust means 36 as a gas mixture after film formation. An exhaust gas from the exhaust means 36 may be treated as necessary with a particle collector or scrubber, being not shown in the drawings.

The atomization of the raw material solution 21 is not particularly limited as long as atomizing or forming droplets of the raw material solution 21 is possible, and any known means may be used; however, an atomizing means 20 using ultrasonic is preferable in the present invention. The mists or droplets obtained by using the ultrasonic waves are preferable because of having an initial velocity of zero and floating in an air; thus, for example, it is the mist that can be transported as a gas floating in the air, not sprayed like a spray, resulting in very suitable for causing no damage due to collision energy. The droplet size is not particularly limited and may be the droplet having about a few mm, preferably 50 µm or less, more preferably 0.1 to 10 µm.

The carrier gas 11 is not particularly limited and, for example, air, oxygen, ozone, inert gases such as nitrogen and argon, or reducing gases such as hydrogen gas and forming gas are suitably used. The type of carrier gas 11 may be one type or two or more types. The flow rate of the carrier gas may be determined as appropriate according to a substrate size or the size of the film forming unit and can be, for example, about 0.01 to 100 L/min.

Although not shown in the drawing, it is possible that a diluent gas is further added to adjust the ratio of the raw material mist 22 to the carrier gas 11. A flow rate of the diluent gas may be determined as appropriate, e.g., 0.1 to 10 times the amount of the carrier gas. The diluent gas may be supplied to, e.g., a downstream side of the atomizing means 20. As the diluent gas, the same gas or a different gas from the carrier gas 11 can be used.

In addition, although the film formation may be performed under any atmospheric pressurized, pressurized, or depressurized conditions, forming under atmospheric pressure is preferred in terms of apparatus cost and productivity.

Although FIG. 1 shows a form to use one atomizing means 20, the film forming apparatus 1 usable in the inventive film forming method is not limited to this, and a plurality of the atomizing means 20 can be connected for use in series or parallel. In this case, each raw material solution different from the others may be stored and used in each of the atomizing means 20, or the same raw material solution may be stored and used. Moreover, each raw material solution may be separately atomized and independently supplied to the gas mixture supply means 35, or a plurality of types of raw material mists may be mixed and then supplied to the gas mixture supply means 35.

The mist pipe 24 is not particularly limited as long as the pipe has sufficient stability to the temperature of the raw material solution 21 being used and to the temperature at the connection between the gas mixture supply means 35 and the carrier gas pipe 12. This pipe can be made of resin, metal, glass, or a combination of these materials, depending on the purpose.

A form or a supply method of the gas mixture supply means 35 is not particularly limited, and a known gas mixture supply means can be widely applied. In addition, a shape of the discharge port 35a is not particularly limited and may include a single or a plurality of circular, elliptical, or polygonal shapes, but in order to make the flow of the gas mixture 33 more uniform and laminar flow, for example, the shape having a single slit or a plurality of slits with a ratio of long axis length to short axis length of about 10 times or more is preferable. In this case, a length of the discharge port 35a in a longitudinal direction can be sufficient length in accordance with a shape of the substrate 34.

Moreover, the gas mixture supply means 35 is not particularly limited as long as the means has sufficient stability to the raw material solution 21 being used and to a service temperature, and can be made of resin, metal, glass, ceramic, or a combination of these materials, depending on the purpose.

A shape of the channel plate 31 is not particularly limited, but a plate shape is preferred in order to make the flow of the gas mixture 33 more uniform and laminar flow. In this case, the length in a direction parallel to the longitudinal direction of the discharge port 35a in a slit shape can be a sufficient length in accordance with the shape of the substrate, preferably longer than the length of the discharge port 35a in the longitudinal direction. Moreover, the flow length of the gas mixture 33 in a flow direction (referred to as a channel length) may be determined as appropriate according to various film forming conditions, including physical properties of the raw material solution 21. For example, when the raw material mist 22 is prone to evaporate, i.e., when the mist lifetime is short, adhesion of powder can be prevented more effectively by shortening the channel length. Furthermore, when the mist lifetime is long, a raw material yield can be increased by extending the channel length.

Moreover, the channel plate 31 is not particularly limited as long as the plate has sufficient stability to the raw material solution 21 being used and to a service temperature and can be made of resin, metal, glass, ceramic, or a combination of these materials, depending on the purpose.

A form of exhaust means 36 is not particularly limited, and a known exhaust means can be widely applied, but the exhaust port 36a is preferred to have an opening of a length equal to or longer than a length of the channel plate 31 perpendicular to the gas flow. This allows for maintaining a better flow of the gas mixture 33. Moreover, the exhaust means 36 is not particularly limited as long as the means has sufficient stability to the raw material solution 21 being used and to a service temperature, and can be made of resin, metal, glass, or a combination of these materials, depending on the purpose.

The exhaust amount of the exhaust means 36 may be adjusted as appropriate according to the conditions for film forming, but in order to maintain the laminar flow of the gas mixture 33, the exhaust amount is preferably set at about 70 to 250% relative to the flow rate of the gas mixture 33, more preferably at about 80 to 200%. When the exhaust amount is smaller relative to the flow rate of the gas mixture 33, the gas mixture 33 is exhausted to exhaust means side as it is. In this case, for example, the gas mixture 33 may be discharged outside the apparatus by a casing exhaust provided in a casing, not shown in the drawings, including the film forming unit 30. Alternatively, when the exhaust amount is larger relative to the flow rate of the gas mixture 33, differential air flows in with the gas mixture 33 from the gas mixture supply means 35 side; thus, the flow of the gas mixture 33, flowing in the space 39, is maintained undisturbed in any cases.

The gas mixture supply means 35 and the channel plate 31 includes the temperature adjusting units 35b and 31b, and the temperature adjusting units 35b and 31b are connected to the temperature control unit 37. The temperature T1 of the gas mixture supply means 35 and the temperature T2 of the channel plate 31 are controlled to a predetermined temperature by the temperature control unit 37 via the temperature adjusting units 35b and 31b.

Measurements of T1 and T2 are not particularly limited but can be measured values on outer surfaces, respectively; it is preferred that the temperature T2 of the channel plate 31 is a temperature on a surface in contact with the gas mixture 33. For example, when the film formation is accompanied by heating of the substrate 34, it is preferred that the measurements are performed at the gas mixture supply means 35 and the channel plate 31, close to a heat source of the heating means. The measurement can be measured by a known temperature measurement method, and can be measured by a thermocouple and a radiation thermometer.

### (Temperature Conditions)

The temperatures T1 and T2 are determined and controlled as appropriate based on various conditions such as a temperature and physical properties (mainly vapor pressure) of the raw material solution 21 or a solvent used in the raw material solution 21, a supply amount of the gas mixture 33, a mist concentration in the gas mixture 33, a linear velocity between the channel plate 31 and the substrate 34; for example, under a general condition to use water as a solvent, the temperature is preferably from 35°C to 150°C.

That is, a predetermined range of appropriate temperatures T1 and T2 is mainly related to the amount of heat received after introducing the gas mixture 33 into the gas mixture supply means 35. For example, when an amount of heat in a system from the gas mixture supply means 35 to the exhaust means 36 is too small relative to the mist concentration and the temperature, etc., of the gas mixture 33, a normal film formation is not performed due to condensation of the raw material mist 22 in this system and then the condensation falls on the substrate and forms a defect. Conversely, the amount of heat is too much in the system, evaporation of the solvent in the raw material solution 21 is excessively progressed and thus, much of the raw material is consumed by forming powder, which not only reduces a film growth rate but also causes the powder to adhere to the film and may further introduce defects into the film, thereby degrading film quality. In some cases, the concentration of a solid component in the mist increases as the temperature of the mist rises, and some undesirable chemical reactions may progress, resulting in abnormality in a desired film formation. For example, in the case of epitaxial growth of α-phase gallium oxide on a sapphire substrate, when the temperature rise of the mist progresses excessively as described above, abnormal growth grains may be formed, and crystal phase transition may appear.

In this case, abnormal growth grains are mainly amorphous or crystalline fine grains grown on a precipitate derived from a solid content of the mist and often have a diameter of submicron to about 1 µm. In addition, a crystal phase transition here is a manifestation of different crystal polymorphism while its composition is the same as a growth film; specifically, each phase of β, γ, ε, δ is included. These crystal phase transitions vary in shape and size depending on crystal phases but are often generated in an island shape of 1 to 5 µm. These abnormal growth grains thereof are a source of dislocation and degrade the film quality; in addition, when these foreign substances are incorporated into the film as the film growth progresses, stress is generated between the growing film and the foreign substances, and cracks are generated in the film, thereby significantly degrading the quality of the film.

Note that these foreign substances can be detected by known methods such as an optical microscope and light scattering.

### (Control Method)

The temperature control unit 37 measures T1 and T2, or a temperature T1' of a temperature adjusting unit 35b and a temperature T2' of a temperature adjusting unit 31b; and controls T1 and T2 directly or indirectly via the temperature adjusting units 35b and 31b so as to eliminate deviations between the measured values and predetermined values (reference values) of T1 and T2. The control of T1 and T2 using T1' and T2' can be performed, for example, by measuring a correlation between T1 and T2 at predetermined film forming conditions and T1' and T2' at this time.

A method for calculating the above deviations is not particularly limited, and known methods can be used. Moreover, the method for controlling temperature is not particularly limited, and known methods such as on-off control, PID control, and cascade control can be used.

A structure, etc., of the stage 32 is not particularly limited as long as sufficient stability is provided according to the characteristics of the raw material used or the temperature conditions. In this case, metals such as aluminum and stainless steel may be used; when the film is formed at a higher temperature exceeding the heat-resistant temperature of these metals, or when acid or alkaline raw materials are used, alloys such as Hastelloy, or ceramics such as soda-lime glass, borosilicate glass, quartz, silicon carbide, silicon nitride, or aluminum nitride may also be used.

Although not shown in the drawing, the film forming unit 30 may be further provided with known heating means such as a resistance heating heater or a lamp heater for heating the substrate 34. In this case, the heater may be built in the stage 32, for example, or may be arranged outside the stage 32. Moreover, the stage 32 may be provided with a mechanism for holding the substrate 34. In this case, known substrate-holding methods such as a vacuum chuck, a mechanical clamp, and an electrostatic chuck can be applied.

The substrate 34 is not particularly limited as long as the film to be formed can be supported. The material of the substrate 34 is also not particularly limited and can be any known material and can be an organic compound or an inorganic compound. For example, polysulfone, polyethersulfone, polyphenylene sulfide, polyether ether ketone, polyimide, polyetherimide, fluororesin; metals such as iron, aluminum, stainless steel, and gold; silicon, sapphire, quartz, glass, calcium carbonate, lithium tantalate, lithium niobate, gallium oxide, SiC, ZnO, and GaN can be mentioned but are not limited thereto. The shape of the substrate may be, for example, plate-shaped such as a flat plate or a disk, fibrous, rod-shaped, columnar, prismatic, tubular, spiral, spherical, ring-shaped, or the like, and any of these shapes is acceptable; particularly, when the substrate has the plate-shaped body, the substrate having an area of 5 cm² or larger, more preferably 10 cm² or larger and a thickness of 50 to 2000 µm, more preferably 100 to 800 µm can be suitably used, although the present invention is not limited thereto.

In addition, in the inventive film forming method, the substrate 34 and the channel plate 31 may form the film while facing each other and standing still at a predetermined position or may be provided with moving means (not shown) or rotating means (not shown) to change relative position with the substrate 34 in the horizontal direction. By being provided with the moving means or the rotating means, a thickness distribution of the film to be formed can be improved, and the film forming to a large diameter substrate and a long substrate is enabled.

The moving means may be a reciprocating mechanism in a horizontal and uniaxial direction, **e.g.,** when moving in a direction parallel to the direction of the mist flow, moving speed may be adjusted as appropriate according to the purpose but may be preferably 0.1 mm/s to 100 mm/s, more preferably 1 mm/s or more and 30 mm/s or less. When the moving speed is 1 mm/s or more, the film formation can be prevented from being determined by reaction rate, sufficient yield of the raw material can be achieved, and an occasion of abnormal reaction can be reduced. When the moving speed is 100 mm/s or less, the gas mixture 33 can sufficiently follow moving motion, and an excellent film thickness distribution can be achieved. In the case of rotation, a rotating rate is not particularly limited as long as the rate is within a range without generating turbulence in the gas mixture 33, but generally, the rotation at 1° per second to 180° per second is preferable.

Note that, in the form in FIG. 1, the channel plate 31 is arranged above the stage 32, and this form shows that the film is formed with a forming surface of the substrate 34 facing upward, but the film forming apparatus used in the film forming method of the present invention is not limited to thereto, and the apparatus may arrange the channel plate 31 below the stage 32, and configure to form the film with the forming surface of the substrate 34 facing downward.

FIG. 1 shows an example of the form to control the temperatures of the gas mixture supply means 35 and the channel plate 31, but the present invention is not limited thereto, and it is also possible that a form has the exhaust means 36 being further installed with a temperature adjusting unit 36b and connected with the temperature control unit 37 to control the temperature T3 of the exhaust means 36. In this case, T3 can be controlled in the same way as in the cases of T1 and T2 described above. Moreover, the temperature T3 is set and controlled based on various conditions such as the temperature and physical properties (mainly vapor pressure) of the raw material solution 21 or that of the solvent used in the raw material solution 21, the supply amount of the gas mixture 33, the mist concentration in the gas mixture 33, and the linear velocity between the channel plate 31 and the substrate 34 but, for example, under general conditions in which water is used as a solvent, the temperature is preferably set between 35°C and 150°C. When T3 is equal to or higher than a certain temperature, the raw material mist 22 is not condensed in the exhaust means 36 and does not fall on the substrate 34 to form the defect. Alternatively, when T3 is equal to or lower than a certain temperature, a solid content of the raw material mist 22 is not precipitated in the exhaust means 36; thus, the exhaust port is not blocked, and the normal forming is enabled.

Consequently, the precipitate does not fall on the substrate 34 to form the defect. By controlling T3 in this way, the discharge of the gas mixture can be performed more effectively, allowing more stable production of the high-quality film.

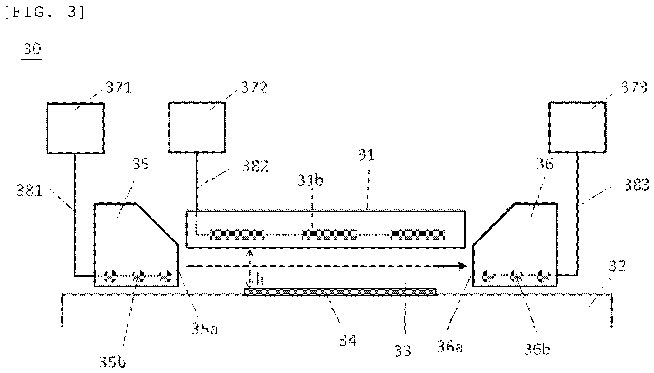

Next, the form of the film forming unit 30 of the present invention is described in more detail using FIGs. 2 and 3.

In the film forming unit 30 shown in FIG. 2, the channel plate 31 is arranged parallel to the stage 32, and the gas mixture supply means 35 and the exhaust means 36 are arranged with the channel plate 31 being sandwiched therebetween such that the mist discharge port 35a of the gas mixture supply means 35 and the exhaust port 36a of the exhaust means 36 are faced each other. The gas mixture supply means 35, the channel plate 31, and the exhaust means 36 are provided with the temperature adjusting units 35b, 31b, and 36b, respectively; and connected in series to the temperature control unit 37 by the connecting unit 38. Note that 33 is the gas mixture, and 34 is the substrate.

The arrangement and the form of the temperature adjusting units 35b, 31b, and 36b may be adjusted as appropriate according to the shape and form of the gas mixture supply means 35, the channel plate 31, and the exhaust means 36. Moreover, the temperature adjusting units 35b, 31b, and 36b may use a heating medium of liquid or gas for heat exchange, or may apply the Peltier effect. As for the heating medium, a known heating medium can be widely used; for example, liquids such as water, glycols, alcohols, and silicon oils, and gaseous heating mediums such as air, helium, or fluorocarbons are suitably used. The connecting unit 38 can be an electrical wiring, or piping suitable for the heating medium according to the form of the temperature adjusting units 35b, 31b, and 36b.

In addition, a distance "h" between the channel plate 31 and the main surface of the substrate 34 is adjusted as appropriate according to, e.g., the supply amount of the gas mixture 33 but typically 1 mm or more and 40 mm or less. When "h" is 1 mm or more, the film thickness distribution tends to be smaller, and when "h" is 40 mm or less, the gas mixture supply amount to the substrate 34 is increased, resulting in higher productivity, improved raw material yield, and lowered cost.

In the form of FIG. 2, the temperature adjusting units 35b, 31b, and 36b are connected in series with the temperature control unit 37, but the present invention is not limited thereto, and as shown in FIG. 3, a form may be provided in which temperature control units 371, 372, and 373 are provided separately for each of the gas mixture supply means 35, the channel plate 31, and the exhaust means 36 to adjust the temperature adjusting units 35b, 31b, and 36b, respectively. Note that 32 is the stage, 34 is the substrate, and 381, 382, and 383 are the connecting units.

In the examples shown in FIGs. 1, 2, and 3, the form of the apparatus is shown in which the gas mixture supply means 35, the channel plate 31, and the exhaust means 36 are arranged separately, but the present invention is not limited thereto, and a part of or all of the gas mixture supply means 35, the channel plate 31, and the exhaust means 36 may be integrally configured.

In the inventive laminate, a density of a foreign substance having a diameter of 0.3 µm or more on a surface of a crystal film is 1 cm⁻² or less, and the lower limit thereof is not particularly limited but, for example, can be 0.1 cm⁻² or more.

In addition, a film thickness of the crystal film is preferably 0.3 µm or more, and the upper limit is not particularly limited but, for example, can be 100 µm or less.

### [Film Forming Method]

The present invention provides a film forming method comprising the steps of:
atomizing a raw material solution to form a raw material mist;
mixing the raw material mist and a carrier gas to form a gas mixture;
placing a substrate on a stage;
forming a film on the substrate by a thermal reaction by supplying the gas mixture to the substrate from a gas mixture supply means; and
exhausting the gas mixture after the film formation by an exhaust means, wherein
a channel plate is arranged above the substrate so as to face the substrate via a space,
a gas mixture flow is formed in the space above the substrate flowing linearly from the gas mixture supply means to the exhaust means such that the gas mixture flow flows along at least a part of a main surface of the substrate, and
in the forming step and the exhausting step, at least a temperature T1 of the gas mixture supply means, and a temperature T2 of the channel plate are controlled.

According to such a film forming method, degeneration of the raw material mist and generation of powder is suppressed, suppressing formation of a defect; moreover, a raw material yield is satisfactorily maintained, making the film forming method capable of stably producing a high-quality film on a large-diameter substrate surface.

In addition, a temperature T3 of the exhaust means can be further controlled. According to such a film forming method, discharge of the gas mixture can be performed more efficiently, resulting in the film forming method capable of producing the high-quality film more stably.

### EXAMPLE

Hereinafter, the present invention will be specifically described with reference to Examples and Comparative Examples. However, the present invention is not limited thereto.

### (Example 1)

In a film forming apparatus of FIG. 1, an α-gallium oxide film was formed using a film forming unit in FIG. 3.

As a raw material solution, Gallium acetylacetonate was dissolved at a ratio of 0.02 mol/L in a dilute aqueous hydrochloric acid solution in which hydrochloric acid having a concentration of 34% was added at a volume ratio of 1%, and the solution was filled into an atomizer (atomizing means).

Next, with an ultrasonic vibration plate, ultrasonic vibration was propagated through water to the raw material solution in the atomizer to atomize (misted) the raw-material solution.

Next, a c-plane single-crystal sapphire wafer having a thickness of 0.35 mm and a diameter of 4 inches (about 10 cm) was placed on a stage and heated such that the substrate temperature reached 450°C.

Moreover, nozzles made of aluminum subjected to an alumite process on a surface were used for a gas mixture supply means and an exhaust means, and a plate also made of aluminum subjected to an alumite process on a surface was used for a channel plate. Water was circulated as a heating medium through a temperature adjusting unit of the nozzles and the channel plate by a chiller to maintain a temperature at a bottom surface portion of each member at 60°C.

A gas cylinder filled with nitrogen gas was used to supply a carrier gas. The gas cylinder was connected to the atomizer with a urethane resin tube, and the atomizer was further connected to the nozzle unit with a quartz pipe.

Next, nitrogen gas was added in a raw material container at a flow rate of 20 L/min to supply a gas mixture of mist and nitrogen gas to the nozzle unit, and an exhaust flow rate was set to 25 L/min to perform exhaust. In the meantime, the stage was transported horizontally while keeping the distance between the channel plate and a substrate surface at 3 mm, and film forming was performed for 20 minutes.

Immediately after this, the supply of the nitrogen gas was stopped and the gas mixture supply to the nozzle unit was stopped.

The produced film was confirmed to be α-phase Ga₂O₃ by X-ray diffraction measurement.

Subsequently, a film thickness of the produced film was measured by ellipsometry at 9 points in a plane in the cross direction from the center of the substrate, and an average value was calculated. Moreover, a density of foreign substance (with a diameter of 0.3 µm or larger) in a region of a film formed surface except for an outer edge width of 5 mm was evaluated by a substrate inspector (KLA candela-CS10).

### (Example 2)

A film was formed in the same way as in Example 1, except that temperatures of the bottom surface portion of a gas mixture supply nozzle and the channel plate were maintained at 60°C, and an exhaust nozzle was not temperature-adjusted (circulating water did not flow).

The produced film was confirmed to be α-phase Ga₂O₃ by X-ray diffraction measurement.

Subsequently, a film thickness of the produced film was measured by ellipsometry at 9 points in a plane, and an average value was calculated. Moreover, a density of foreign substance (with a diameter of 0.3 µm or larger) in a region of a film formed surface except for an outer edge width of 5 mm was evaluated by a substrate inspector (KLA candela-CS10).

### (Comparative Example 1)

A film was formed in the same way as in Example 1, except that a temperature of a bottom surface portion of a gas mixture supply nozzle was maintained at 60°C and a film forming apparatus was used in which a temperature control means for a channel plate and an exhaust nozzle was not provided.

The produced film was confirmed to be α-phase Ga₂O₃ by X-ray diffraction measurement.

Subsequently, a film thickness of the produced film was measured by ellipsometry at 9 points in a plane, and an average value was calculated. Moreover, a density of foreign substance (with a diameter of 0.3 µm or larger) in a region of a film formed surface except for an outer edge width of 5 mm was evaluated by a substrate inspector (KLA candela-CS10).

### (Comparative Example 2)

A film was formed in the same way as in Example 1, except that a film forming apparatus was used in which a temperature control means for all of the gas mixture supply nozzle, channel plate, and exhaust nozzle were not provided.

The produced film was confirmed to be α-phase Ga₂O₃ by X-ray diffraction measurement and also confirmed the presence of a trace amount of ε-phase.

Subsequently, a film thickness of the produced film was measured by ellipsometry at 9 points in a plane, and an average value was calculated. Moreover, a density of foreign substance (with a diameter of 0.3 µm or larger) in a region of a film formed surface except for an outer edge width of 5 mm was evaluated by a substrate inspector (KLA candela-CS10).

### (Example 3)

A film formation of hafnium oxide was performed using the film forming unit in FIG. 2 in the film forming apparatus in FIG. 1.

As a raw material solution, the solution in which hafnium acetylacetonate (IV) was dissolved in ethanol at a ratio of 0.02 mol/L was provided and filled into an atomizer. The atomizer provided with two ultrasonic vibration plates (frequency: 2.4 MHz) was used.

Next, with the ultrasonic vibration plate, ultrasonic vibration was propagated through water to the raw material solution in the atomizer to atomize (misted) the raw-material solution.

Next, a single-crystal silicon wafer having a thickness of 0.35 mm and a diameter of 4 inches (about 10 cm) was placed on a stage made of SiC having a built-in resistance heating heater and then heated to 400°C.

Moreover, nozzles made of aluminum subjected to an alumite process on a surface were used for a gas mixture supply means and an exhaust means, and a plate also made of aluminum subjected to an alumite process on a surface was used for a channel plate. Ethylene glycol-based circulating liquid was circulated as a heating medium through a temperature adjusting unit of the nozzles and the channel plate by a chiller to maintain a temperature at a bottom surface portion of each member at 20°C.

A gas cylinder filled with nitrogen gas was used to supply a carrier gas. The gas cylinder was connected to the atomizer with a urethane resin tube, and the atomizer was further connected to the nozzle unit with a quartz pipe.

Next, nitrogen gas was added in a raw material container at a flow rate of 20 L/min to supply a gas mixture of mist and nitrogen gas to the nozzle unit, and an exhaust flow rate was set to 25 L/min to perform exhaust. In the meantime, the stage was transported horizontally while keeping the distance between the channel plate and a substrate surface at 3 mm, and film forming was performed for 20 minutes.

Immediately after this, the supply of the nitrogen gas was stopped and the gas mixture supply to the nozzle unit was stopped.

The produced film was confirmed to be HfO₂ by XPS measurement and ellipsometry.

Subsequently, a film thickness of the produced film was measured by ellipsometry at 9 points in a plane, and an average value was calculated. Moreover, a density of foreign substance (with a diameter of 0.3 µm or larger) in a region of a film formed surface except for an outer edge width of 5 mm was evaluated by a substrate inspector (KLA candela-CS10).

### (Comparative Example 3)

A film was formed in the same way as in Example 3, except that a film forming apparatus was used in which temperature control means for all of the gas mixture supply nozzle, channel plate, and exhaust nozzle were not provided.

XPS measurement was then performed, and it was found that any films were not formed on a substrate.

Thereafter, a film thickness measurement and a foreign substance measurement were performed as in Example 1.

### (Example 4)

A film formation of silicon oxide film was formed using the film forming unit in FIG. 2 in the film forming apparatus in FIG. 1.

As a raw material solution, the solution in which polysilazane was dissolved in ethylene glycol at a ratio of 0.02 mol/L and then hydrogen peroxide water was added therein at a volume ratio of 5% was provided and filled into an atomizer. The atomizer provided with two ultrasonic vibration plates (frequency: 2.4 MHz) was used.

Next, with the ultrasonic vibration plate, ultrasonic vibration was propagated through water to the raw material solution in the atomizer to atomize (misted) the raw-material solution.

Next, a single-crystal silicon wafer having a thickness of 0.35 mm and a diameter of 4 inches (about 10 cm) was placed on a stage made of SiC having a built-in resistance heating heater and then heated to 250°C.

Moreover, nozzles made of aluminum subjected to an alumite process on a surface were used for a gas mixture supply means and an exhaust means, and a plate also made of aluminum subjected to an alumite process on a surface was used for a channel plate. Water was circulated as a heating medium through a temperature adjusting unit of the nozzles and the channel plate by a chiller to maintain a temperature at a bottom surface portion of each member at 35°C.

A gas cylinder filled with nitrogen gas was used to supply a carrier gas. The gas cylinder was connected to the atomizer with a urethane resin tube, and the atomizer was further connected to the nozzle unit with a quartz pipe.

Next, nitrogen gas was added in a raw material container at a flow rate of 20 L/min to supply a gas mixture of mist and nitrogen gas to the nozzle unit, and an exhaust flow rate was set to 25 L/min to perform exhaust. In the meantime, the stage was transported horizontally while keeping the distance between the channel plate and a substrate surface at 3 mm, and film forming was performed for 5 minutes.

Immediately after this, the supply of the nitrogen gas was stopped and the gas mixture supply to the nozzle unit was stopped.

The produced film was found to be SiO₂ from an infrared absorption spectrum.

Subsequently, a film thickness of the produced film was measured by ellipsometry at 9 points in a plane, and an average value was calculated. Moreover, a density of foreign substance (with a diameter of 0.3 µm or larger) in a region of a film formed surface except for an outer edge width of 5 mm was evaluated by a substrate inspector (KLA candela-CS10).

### (Comparative Example 4)

A film was formed in the same way as in Example 4, except that a film forming apparatus was used in which temperature control means for all of the gas mixture supply nozzle, channel plate, and exhaust nozzle were not provided.

Subsequently, an evaluation of the film was performed as in Example 4.

The produced film was found to be SiO₂ from an infrared absorption spectrum.

Thereafter, a film thickness measurement and a foreign substance measurement were performed as in Example 1.

**[Table 1]**

| | Film Thickness [nm] | Foreign Substance Density [cm⁻²] |
|---|---|---|
| Example 1 | 1180 | 0.2 |
| Example 2 | 1156 | 0.6 |
| Example 3 | 240 | 0.4 |
| Example 4 | 653 | 0.1 |
| Comparative Example 1 | 681 | 2754 |
| Comparative Example 2 | 694 | 2625 |
| Comparative Example 3 | No Film Formed | 1268 |
| Comparative Example 4 | 103 | 373 |

Table 1 shows the evaluation results of Examples 1, 2, 3, and 4 and Comparative Examples 1, 2, 3, and 4.

In the films produced by the inventive film forming method, stable film growth was performed, and the densities of foreign substances were suppressed to a low degree. In contrast, in the film formation by the conventional methods, the film thicknesses were decreased, and the densities of foreign substances were clearly increased. This is considered to be a result of excessive heating of the raw material mist, which facilitates the precipitation of solid contents in the mist, resulting in the preferential formation of powder and a decrease in the yield of film formation.

From the above results, it is found that the present invention enables the film forming apparatus to produce higher quality film with higher productivity than the conventional technique.

The present description includes the following embodiments.
[1]: A film forming method comprising the steps of:
   atomizing a raw material solution to form a raw material mist;
   mixing the raw material mist and a carrier gas to form a gas mixture;
   placing a substrate on a stage;
   forming a film on the substrate by a thermal reaction by supplying the gas mixture to the substrate from a gas mixture supply means; and
   exhausting the gas mixture after the film formation by an exhaust means, wherein
   a channel plate is arranged above the substrate so as to face the substrate via a space,
   a gas mixture flow is formed in the space above the substrate flowing linearly from the gas mixture supply means to the exhaust means such that the gas mixture flow flows along at least a part of a main surface of the substrate, and
   in the forming step and the exhausting step, at least a temperature T1 of the gas mixture supply means, and a temperature T2 of the channel plate are controlled.
[2]: The film forming method of the above [1], wherein
   a temperature T3 of the exhaust means is further controlled.
[3]: A film forming method comprising the steps of:
   atomizing a raw material solution to form a raw material mist;
   mixing the raw material mist and a carrier gas to form a gas mixture;
   placing a substrate on a stage;
   forming a film on the substrate by a thermal reaction by supplying the gas mixture to the substrate from a gas mixture supply means; and
   exhausting the gas mixture after the film formation by an exhaust means, wherein
   a channel plate is arranged above the substrate so as to face the substrate via a space,
   a gas mixture flow is formed in the space above the substrate flowing linearly from the gas mixture supply means to the exhaust means such that the gas mixture flow flows along at least a part of a main surface of the substrate, and
   in the forming step and the exhausting step, at least a temperature T2 of the channel plate is controlled.
[4]: The film forming method of the above [3], wherein
   a temperature T3 of the exhaust means is further controlled.
[5]: A film forming apparatus comprising:
   an atomizing means for atomizing a raw material solution to form a raw material mist;
   a carrier gas supply means to transport the raw material mist;
   a gas mixture supply means to supply a gas mixture, in which the raw material mist and the carrier gas are mixed, to a surface of a substrate;
   a stage on which the substrate is placed;
   an exhaust means to exhaust the gas mixture;
   a channel plate arranged above the substrate so as to face the substrate via a space; and
   a temperature control means to control at least a temperature T1 of the gas mixture supply means and a temperature T2 of the channel plate.
[6]: The film forming apparatus of the above [5], wherein
   the film forming apparatus further comprises a temperature control means to control a temperature T3 of the exhaust means.
[7]: A laminate comprising:
   a crystal substrate; and
   a crystal film epitaxially grown on the crystal substrate, wherein
   a density of a foreign substance having a diameter of 0.3 µm or more on a surface of the crystal film is 1 cm⁻² or less.
[8]: The laminate of the above [7], wherein
   the crystal film has a film thickness of 0.3 µm or more.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A film forming method comprising the steps of:
atomizing a raw material solution to form a raw material mist;
mixing the raw material mist and a carrier gas to form a gas mixture;
placing a substrate on a stage;
forming a film on the substrate by a thermal reaction by supplying the gas mixture to the substrate from a gas mixture supply means; and
exhausting the gas mixture after the film formation by an exhaust means, wherein
a channel plate is arranged above the substrate so as to face the substrate via a space,
a gas mixture flow is formed in the space above the substrate flowing linearly from the gas mixture supply means to the exhaust means such that the gas mixture flow flows along at least a part of a main surface of the substrate, and
in the forming step and the exhausting step, at least a temperature T1 of the gas mixture supply means, and a temperature T2 of the channel plate are controlled.

2. The film forming method according to claim 1, wherein
a temperature T3 of the exhaust means is further controlled.

3. A film forming method comprising the steps of:
atomizing a raw material solution to form a raw material mist;
mixing the raw material mist and a carrier gas to form a gas mixture;
placing a substrate on a stage;
forming a film on the substrate by a thermal reaction by supplying the gas mixture to the substrate from a gas mixture supply means; and
exhausting the gas mixture after the film formation by an exhaust means, wherein
a channel plate is arranged above the substrate so as to face the substrate via a space,
a gas mixture flow is formed in the space above the substrate flowing linearly from the gas mixture supply means to the exhaust means such that the gas mixture flow flows along at least a part of a main surface of the substrate, and
in the forming step and the exhausting step, at least a temperature T2 of the channel plate is controlled.

4. The film forming method according to claim 3, wherein
a temperature T3 of the exhaust means is further controlled.

5. A film forming apparatus comprising:
an atomizing means for atomizing a raw material solution to form a raw material mist;
a carrier gas supply means to transport the raw material mist;
a gas mixture supply means to supply a gas mixture, in which the raw material mist and the carrier gas are mixed, to a surface of a substrate;
a stage on which the substrate is placed;
an exhaust means to exhaust the gas mixture;
a channel plate arranged above the substrate so as to face the substrate via a space; and
a temperature control means to control at least a temperature T1 of the gas mixture supply means and a temperature T2 of the channel plate.

6. The film forming apparatus according to claim 5, wherein
the film forming apparatus further comprises a temperature control means to control a temperature T3 of the exhaust means.

7. A laminate comprising:
a crystal substrate; and
a crystal film epitaxially grown on the crystal substrate, wherein
a density of a foreign substance having a diameter of 0.3 µm or more on a surface of the crystal film is 1 cm⁻² or less.

8. The laminate according to claim 7, wherein
the crystal film has a film thickness of 0.3 µm or more.
